(19) Europäisches Patentamt
European Patent Office
Office européen des brevets

(11) **EP 1 898 228 A2**

(12) **EUROPEAN PATENT APPLICATION**

(43) Date of publication:
**12.03.2008 Bulletin 2008/11**

(51) Int Cl.:
***G01R 33/34*** *(2006.01)*

(21) Application number: **07015695.5**

(22) Date of filing: **09.08.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **08.09.2006 JP 2006244041**

(71) Applicant: **Hitachi, Ltd.**
**Chiyoda-ku**
**Tokyo (JP)**

(72) Inventors:
• **Takahashi, Masaya**
**Chiyoda-ku**
**Tokyo 100-8220 (JP)**

• **Tanaka, Kazuhide**
**Chiyoda-ku**
**Tokyo 100-8220 (JP)**
• **Kawasaki, Kenji**
**Chiyoda-ku**
**Tokyo 100-8220 (JP)**
• **Shiino, Toshiyuki**
**Chiyoda-ku**
**Tokyo 100-8220 (JP)**
• **Okada, Michiya**
**Chiyoda-ku**
**Tokyo 100-8220 (JP)**

(74) Representative: **Beetz & Partner**
**Steinsdorfstrasse 10**
**D-80538 München (DE)**

(54) **Antenna coil for nmr with reduced magnetic susceptibility**

(57)    The invention relates to an antenna coil for an NMR probe, wherein the coil is made of a wire rod (1; 11) obtained by combining and integrating two or more kinds of materials (2, 3; 10, 7) having different magnetisms such as diamagnetism and paramagnetism. The wire rod (1; 11) has a circular, rectangular or polygonal cross-sectional shape. The two or more kinds of materials having different magnetisms are combined so that the magnetisms of the combined materials are set off. The wire rod (1; 11) is wound around a bobbin so as to have a solenoid shape. The low-magnetic wire rod (11) preferably comprises superconductive filaments (14) in its outer peripheral portion. The wire rod or the antenna coil is preferably placed in an atmosphere whose temperature has been reduced to 10 K or less. Preferably, a part of the superconductive filaments (14) are exposed on the wire rod surface.

## FIG.7

EP 1 898 228 A2

**Description**

BACKGROUND OF THE INVENTION

Field of the Invention

The invention relates to an antenna coil for an NMR probe in a nuclear magnetic resonance (NMR) apparatus, the probe being applied to transmit a high frequency signal at a predetermined resonance frequency to a sample put in a uniform magnetic field and receive a free induction damping (FID) signal. The invention also relates to wire rods for use in such antenna coils and to NMR systems.

Description of the Related Art

The probe for the NMR is constructed by an antenna coil for transmitting a high frequency signal and receiving an FID signal, a coil bobbin, an electric circuit, and the like. By combining the antenna coil with a capacitor for tuning, a tuning circuit is formed and the FID signal generated by a resonator in the sample by irradiation of high-frequency pulses is received.

High sensitivity is required for the NMR probe which receives the FID signal generated in response to the high-frequency pulses. This is because when the amount of a measurement sample such as a protein is small, since the intensity of the FID signal is particularly weak, it takes a long time for measurement because of the low sensitivity. To improve the sensitivity, it is effective to increase the Q value of the tuning circuit. The Q value is a value representing the sharpness of a peak in the resonance circuit and is obtained by the following equation:

$$Q = \frac{1}{R} \sqrt{\frac{L}{C}} \qquad\qquad (1),$$

where,

> R: resistance
> C: capacitance
> L: inductance

Excellent resolution is also necessary for the NMR probe. To improve the resolution, it is effective to reduce the magnetic susceptibility peculiar to the substance forming an antenna coil and reduce the distortion of the magnetostatic field to a minimum value.

As an antenna coil which satisfies those characteristics, an antenna coil made of a laminate formed by alternately adhering a paramagnetic metal foil and a diamagnetic metal foil has been proposed (for example, refer to JP-A-2003-11268 (Abstract)).

According to the antenna coil comprising a laminate formed by alternately adhering the paramagnetic metal foil and the diamagnetic metal foil, a structure having a low magnetic susceptibility can be obtained by adjusting the mixture ratio of materials which are used according to a combination of thicknesses of the foil, film, and plate so that the low magnetism is obtained. However, since the thickness of material is small, and the face resistance (R) of the material cross-section is small, an improvement of the Q value cannot be expected. In such a case, to improve the Q value, it is necessary to enlarge the whole antenna coil and use a multistage antenna structure, resulting in an increase in size of the probe tip portion.

SUMMARY OF THE INVENTION

It is an object of the invention to provide an antenna coil made of a material having both characteristics of a low magnetic susceptibility and a large Q value, its material, and an NMR system.

The above underlying problem is solved according to the independent claims. The dependent claims relate to preferred embodiments of the concept of the present invention.

According to the invention, there is provided an antenna coil for an NMR probe, in which the coil is made of a wire rod having a circular or polygonal cross-sectional shape obtained by combining and integrating two or more kinds of materials having different magnetisms, the magnetisms of the materials assembled by combining the two or more kinds of materials having the different magnetisms are set off, and the coil is formed in a solenoid shape.

According to the invention, there is provided an antenna coil for an NMR probe, in which the coil is made of a wire rod having a circular or polygonal cross-sectional shape obtained by combining and integrating two or more kinds of materials having different magnetisms, the magnetisms of the materials assembled by combining the two or more kinds of materials having the different magnetisms are set off, and the coil is formed in a solenoid shape and is placed in an atmosphere of 10 K or less.

According to the invention, there is provided an antenna coil for an NMR probe, in which superconductive filaments are provided for an outer peripheral portion of a wire rod having a circular or polygonal cross-sectional shape obtained by combining and integrating two or more kinds of materials having different magnetisms, the magnetisms of the materials assembled by combining the two or more kinds of materials having the different magnetisms are set off, and the coil is formed in a solenoid shape and is placed in an atmosphere of 10 K or less.

According to the invention, there is provided an antenna coil for an NMR probe, in which superconductive filaments are provided for an outer peripheral portion of a wire rod having a circular or polygonal cross-sectional shape obtained by combining and integrating two or more kinds of materials having different magnetisms, a part of the superconductive filaments are exposed, the magnetisms of the materials assembled by combining the two or more kinds of materials having the different magnetisms are set off, and the coil is formed in a solenoid shape and is placed in an atmosphere of 10 K or less.

According to the invention, there is provided a low-magnetic wire rod for an antenna coil for an NMR probe, in which the wire rod is obtained by combining and integrating two or more kinds of materials having different magnetisms and has a circular or polygonal cross-sectional shape, and the magnetisms of the materials assembled by combining the two or more kinds of materials having the different magnetisms are set off.

According to the invention, there is provided a low-magnetic superconductive wire rod for an antenna coil for an NMR probe, in which superconductive filaments are provided for an outer peripheral portion of the wire rod having a circular or polygonal cross-sectional shape obtained by combining and integrating two or more kinds of materials having different magnetisms, and the magnetisms of the materials assembled by combining the two or more kinds of materials having the different magnetisms are set off.

According to the invention, there is provided a low-magnetic superconductive wire rod for an antenna coil for an NMR probe, in which superconductive filaments are provided for an outer peripheral portion of the wire rod having a circular or polygonal cross-sectional shape obtained by combining and integrating two or more kinds of materials having different magnetisms, a part of the superconductive filaments are exposed, and the magnetisms of the materials assembled by combining the two or more kinds of materials having the different magnetisms are set off.

According to the invention, the antenna coil wire having both of the large Q value and the low magnetism can be provided. Thus, the NMR probe having both of the high sensitivity and high resolution can be provided.

Other objects, features and advantages of the invention will become apparent from the following description of the embodiments of the invention taken in conjunction with the accompanying drawings.

BRIEF DESCRIPTION OF THE DRAWINGS

Fig. 1 is a cross-sectional view of a wire rod for an antenna coil in an embodiment 1;
Fig. 2 is a cross-sectional view showing a modification of the wire rod for the antenna coil in the embodiment 1;
Fig. 3 is a cross-sectional view showing another example of the wire rod for the antenna coil in the embodiment 1;
Fig. 4 is a cross-sectional view showing another example of the wire rod for the antenna coil in the embodiment 1;
Fig. 5 is a cross-sectional view showing another modification of the wire rod for the antenna coil in the embodiment 1;
Fig. 6 is a cross-sectional view of a wire rod for an antenna coil in an embodiment 2;
Fig. 7 is a cross-sectional view of a wire rod for an antenna coil in an embodiment 3;
Fig. 8 is a cross-sectional view of a wire rod for an antenna coil in an embodiment 4;
Fig. 9 is a cross-sectional view of a wire rod for an antenna coil in an embodiment 5; and
Fig. 10 is a cross-sectional view of a wire rod for an antenna coil in an embodiment 6.

DETAILED DESCRIPTION OF THE EMBODIMENTS

To provide an antenna coil made of a material having both of a low magnetic susceptibility and a larger Q value, it is necessary to reduce the magnetic susceptibility by combining a paramagnetic material and a diamagnetic material and cancelling their mutual magnetic susceptibilities and to simultaneously satisfy the following measures (1) to (3) for improving the Q value.

The measures (1) to (3) for improving the Q value are as follows: (1) the resistance is reduced by forming a material having a small resistance value into a preferably circular wire shape and increasing its cross-sectional area; (2) the resistance is reduced by setting the antenna coil setting place to a low temperature, and (3) the resistance value is reduced to a minimum value by using a superconductive material.

In consideration of the above measures, according to the first embodiment of the invention, two or more kinds of materials having different magnetisms are combined so that the magnetisms are set off, they are integrated by a method such as a cladding process or the like, and a wire rod is formed into a preferably circular or polygonal cross-sectional shape, thereby increasing the cross-sectional area.

According to the second embodiment of the invention, the wire rod having the specifications in the above first embodiment is placed in an atmosphere of a temperature of 10 K or less, preferably, 5 K or less, thereby setting the wire rod to a low temperature.

According to the third embodiment of the invention, a wire rod having a preferably circular or polygonal cross-sectional shape is formed by combining and integrating two or more kinds of materials having different magnetisms so that the magnetisms are set off, superconductive filaments are provided in the outer peripheral portion of the wire rod, and the wire rod is placed in an atmosphere of a temperature of 10 K or less, thereby setting the wire rod to a low temperature.

According to the fourth embodiment of the invention, a part of the superconductive filaments in the third embodiment are exposed.

In the invention, for example, a flat-type shape, a hexagonal shape, a rectangular shape, and the like are incorporated in the purview of the polygonal shape. However, the invention is not limited to them.

It is preferable that the antenna coil is formed into a solenoid shape by using a winding bobbin made of a low-magnetic material.

According to the antenna coil wire rod of the invention, the paramagnetic material and the diamagnetic material are combined so that their magnetisms are set off. As a paramagnetic material, it is desirable to use Al, Pt, Cr, Ta, W, K, Ca, Sc, Ti, V, Mn, Rb, Sr, Y, Zr, Nb, Mo, Tc, Ru, Rh, Pd, or their alloys. As a diamagnetic material, it is desirable to use Au, Ag, Cu, or their alloys.

As a material of the superconductive filaments, it is desirable to use an Nb system superconductor such as NbTi, NbZr, $Nb_3Sn$, $Nb_3Al$, or the like, $MgB_2$, a Bi system oxide superconductive substance, or another oxide superconductive substance.

The antenna coil wire rod of the invention can be formed by a stretching process mainly including an extruding process and a drawing process.

In the invention, if the finished wire rod, that is, the wire rod obtained after completion of the stretching process has magnetism, it is desirable to decrease the magnetism by performing a film-forming or etching process. A specific method in this case will be described hereinbelow.

When the finished wire rod is paramagnetic, if an outermost layer of the wire rod is made of the paramagnetic material, a film is formed by the diamagnetic material or the paramagnetic material in the outermost layer is etched. If the outermost layer is made of the diamagnetic material, a film is formed by the diamagnetic material.

When the finished wire rod is diamagnetic, if the outermost layer of the wire rod is made of the paramagnetic material, a film is formed by the paramagnetic material. If the outermost layer is made of the diamagnetic material, a film is formed by the paramagnetic material or the diamagnetic material in the outermost layer is etched.

An embodiment of the invention will be described hereinbelow. For comparison with the invention, an antenna coil is formed by a laminate obtained by alternately laminating an Al foil and a Cu foil and the magnetic susceptibility and the Q value (resonance occurs at 300 MHz) are measured. Thus, the magnetic susceptibility is equal to $1.5 \times 10^{-7}$ (volume magnetic susceptibility), and the Q value is equal to 300. In the following embodiments, an evaluation of the materials is made by comparing with those data.

[Embodiment 1]

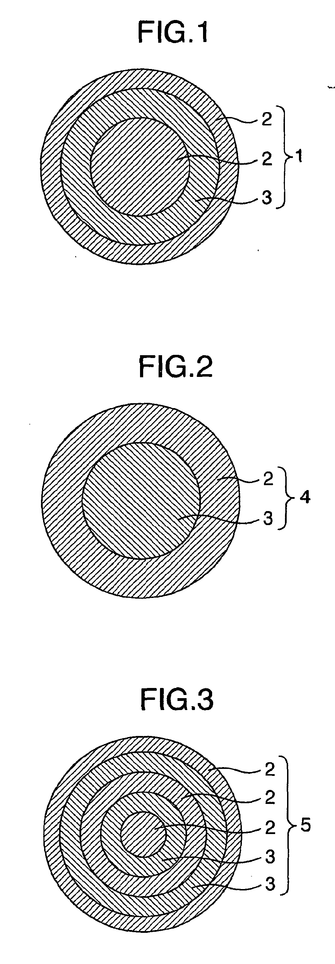

This embodiment relates to an example of a roomtemperature probe material. Fig. 1 shows a cross-sectional structure of a CuAl composite circular wire rod as a low-magnetic wire rod 1 manufactured in this embodiment. In this embodiment, Al is used as a paramagnetic material 3, and Cu is used as a diamagnetic material 2. By forming the material for the antenna coil into a circular shape, the resistance can be reduced and the Q value is improved. Since a structure in which a wire is wound around a bobbin is used, the strength of the whole antenna coil is improved, and a strong NMR probe can be constructed.

Although the outermost layer is made of the diamagnetic material in the embodiment, it may be made of the paramagnetic material. If the outermost layer is made of Cu as in the embodiment, excellent cooling characteristics are obtained. There are also such effects that a melt-bonding with a dice can be prevented upon wire-drawing process, and the stretching process can be easily performed.

A manufacturing process of the wire rod in the embodiment will now be described.

As members necessary for manufacturing the wire rod, a Cu tube for an outermost layer, an Al tube for an intermediate layer, and a Cu rod for an innermost layer are prepared. After they were assembled in the corresponding order, a cladding process is executed by the stretching process, the wire-drawing process is further executed until the diameter of the wire rod reaches 1.0 mm, thereby manufacturing a CuAl composite wire. Dimensions and thicknesses of the Cu tube and Cu rod and dimensions and the thickness of the Al tube in this instance are determined in such a manner that the magnetic susceptibility of a material which is used is preliminarily measured in the same conditions as those of an environment where the antenna coil is used and at such a mixture ratio that the magnetism approaches zero as close as possible is obtained.

As a result of the measurement of the magnetic susceptibility of the manufactured CuAl composite wire, it is equal to $-9.0 \times 10^{-8}$ as a volume magnetic susceptibility. It has been found that the small volume magnetic susceptibility which is almost equal to that obtained according to the mixture ratio is obtained.

Subsequently, the manufactured CuAl composite wire is wound into a solenoid coil shape around a bobbin manufactured from a low-magnetic material such as quartz glass, and the Q value is measured. Thus, the Q value is equal to 500, and it has been found that such a value is larger than that of the Comparison.

By forming the wire rod into a circular shape and increasing a resistance as mentioned above, the antenna coil wire having both of the large Q value and the low magnetism can be formed.

The case where Al is used as a paramagnetic material and Cu is used as a diamagnetic material has been described above. An effect similar to that mentioned above will be obtained even if Pt, Cr, Ta, W, K, Ca, Sc, Ti, V, Mn, Rb, Sr, Y, Zr, Nb, Mo, Tc, Ru, Rh, Pd, or an alloy thereof is used as a paramagnetic material and one of Au, Ag, and their alloys is used as a diamagnetic material. However, when considering the electric resistance, the toughness of the material necessary for manufacturing the wire rod, the costs, or the like, it is desirable to use Al, Ta, or Nb as a paramagnetic material and use Cu or a Cu alloy such as CuNi or CuSn as a diamagnetic material. However, in the case of the alloy, there is a variation in the compositions, and there is a case where the magnetic susceptibility changes depending on the members which are used. Therefore, in the case of using the alloy, it is desirable to form the wire rod by using a material having less impurities.

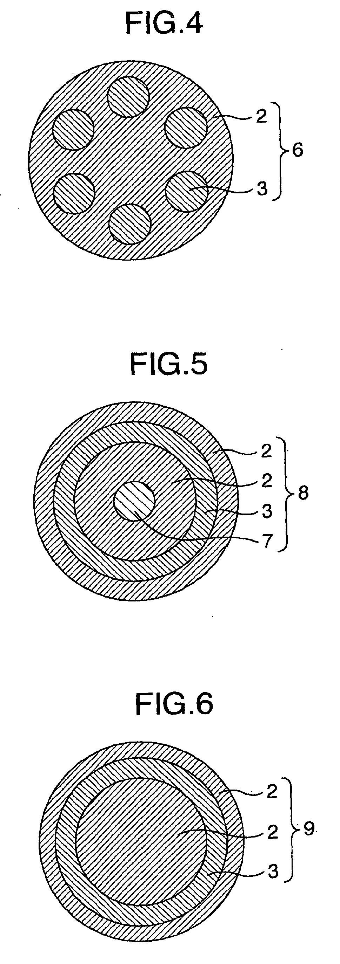

As the cross-sectional structure of the wire rod, wire rods having one of the following structures can be mentioned: a structure of a low-magnetic wire rod 4 in which Al as a paramagnetic material 3 exists in a center portion as shown in Fig. 2; a structure of a low-magnetic wire rod 5 having a quintuple structure as shown in Fig. 3; and a structure of a low-magnetic wire rod 6 having an Al multi-core structure in which Al as a paramagnetic material 3 has been dispersed into the plane of the diamagnetic material 2 as shown in Fig. 4. One of the following structures can also be used: a structure in which the layout of Cu and Al is reversed; a structure of a low-magnetic wire rod 8 in which three kinds of materials are combined by also using two kinds of paramagnetic materials 3 and 7 as shown in Fig. 5; and further a structure in which three or more kinds of materials are combined. A similar effect is obtained even when any one of those structures is used.

As a stretching process, a similar effect is also obtained even by using any one of a drawing bench process, an extruding process, another stretching process, an isostatic pressing process, a rolling process, and the like.

Although the final processing diameter has been set to 1.0 mm at this time, it can arbitrarily be determined according to specifications such as inductance and dimensions of the antenna coil. It is desirable to set the final processing diameter to a value within a range from 0.1 to 3.0 mm from the viewpoint of the actual operation.

Although the volume magnetic susceptibility is equal to $-9.0 \times 10^{-8}$ according to the present manufacturing of the wire rod, if a deviation occurs in the mixture ratio due to an influence upon stretching, the low magnetism can also be realized by forming a predetermined film to the outermost layer and finely adjusting it. If the finished wire rod is paramagnetic, it is desirable to form the film made of a diamagnetic material such as Cu or Ag. If the finished wire rod is diamagnetic, it is desirable to form the film made of a paramagnetic material such as Pt or V. Since the film-forming technique in the case of using Cu, Ag, Pt, or V has already been established, such a material is particularly preferable as a film-forming material. Upon film forming, it is desirable to set the film thickness at such a level and to use such a material that no influence is exerted on current supplying characteristics obtained after the film forming. As a film forming method, any one of the dry type and the wet type may be used, and its manufacturing method is not particularly limited. However, it is desirable to use a method whereby the film thickness can easily be adjusted.

Although the wire rod has been formed into a circular shape, an effect similar to that mentioned above is obtained even if it has a flat-type shape, a hexagonal shape, or a rectangular shape.

[Embodiment 2]

In order to obtain a larger Q value than that in the case of the embodiment 1, it is necessary to further reduce the resistance of the wire rod. For this purpose, such a technique that the antenna coil is used at 5 K where the resistance of the material is decreased has been examined.

Fig. 6 shows the cross-sectional structure of a CuA1 composite circular wire rod which is used as a low-magnetic wire rod 9 manufactured in accordance with this embodiment. In this embodiment as well, Al is used as a paramagnetic material 3, and Cu is used as a diamagnetic material 2. The embodiment 2 differs from the embodiment 1 with respect to the point that the measurement of the magnetic susceptibility of the used material which is measured is preliminarily made at 5 K, and the mixture ratio is set based on the measurement result so that the magnetism approaches zero as close as possible. As a result of the present trial manufacture, it has been found that since the wire rod is used for a low temperature, it is necessary to reduce the amount of A1.

A manufacturing process of the embodiment 2 will be described hereinbelow.

As members necessary for manufacturing the wire rod, a Cu tube for the outermost layer, an Al tube for the intermediate layer, and a Cu rod for the innermost layer are prepared. After they were assembled in the corresponding order, the cladding process is carried out by the stretching process, the wire-drawing process is further executed until the rod diameter reaches 1.0 mm, thereby manufacturing the CuAl composite wire.

As a result of the measurement of the magnetic susceptibility of the manufactured CuA1 composite wire, it is equal to $-7.0 \times 10^{-8}$ as a volume magnetic susceptibility. It has been found that the small volume magnetic susceptibility which is almost equal to that obtained according to the mixture ratio is obtained.

Subsequently, the manufactured CuAl composite wire is wound into a solenoid coil shape around a bobbin manufactured from the low-magnetic material such as quartz glass, and the Q value is measured. Thus, the Q value is equal to 1000, and it has been found that such a value is larger than that of the Comparison. It has also been found that by setting the wire rod at a super-low temperature such as 5 K or the like, the Q value is further improved.

By forming the wire rod into a circular shape, increasing the cross-sectional area, increasing the resistance, and further using the wire rod at the super-low temperature as mentioned above, the antenna coil wire having both of the large Q value and the low magnetism can be formed. Although the setting atmosphere of the wire rod has been set to a temperature of 5 K in this embodiment, so long as the wire rod is in the atmosphere of a temperature of 10 K or less, the improving effect of the Q value is obtained.

[Embodiment 3]

Although the improvement of the magnetic susceptibility and the Q value can also be sufficiently effected in the embodiments 1 and 2, in order to obtain the larger Q value, it is necessary to further decrease the resistance. For this purpose, such a technique for reducing the wire rod resistance to a minimum value by making the antenna coil superconductive has been examined.

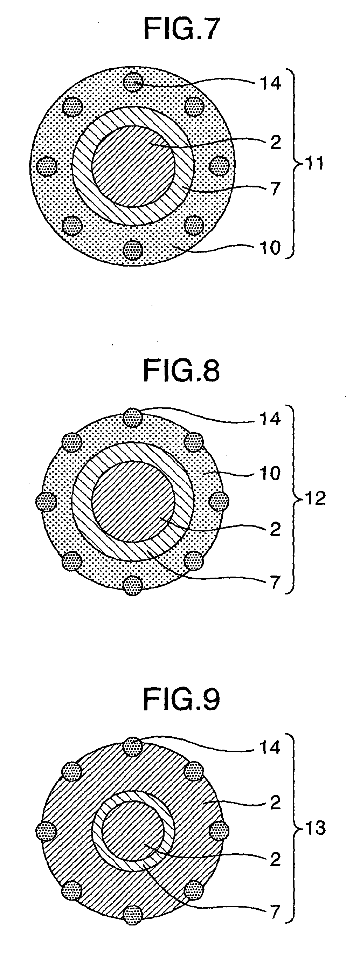

Fig. 7 shows the cross-sectional structure of an $Nb_3Sn$ composite circular wire rod which is used as a low-magnetic superconductive wire rod 11 manufactured in the embodiment 3. In the embodiment, a Ta tube is used as a paramagnetic material 7, a Cu rod is used as a diamagnetic material 2, a CuSn alloy is used as a diamagnetic material 10, and a multi-core $Nb_3Sn$ forming wire is used for the superconductive filaments 14.

By forming the material for the antenna coil into a circular shape, the antenna coil is made superconductive, so that the resistance can be extremely reduced, and the Q value is fairly improved. Since the antenna coil has such a structure that the wire is wound around the bobbin, the strength of the whole antenna coil is improved and a strong NMR probe can be formed.

A manufacturing process of the embodiment 3 will be described hereinbelow.

A single-core $Nb_3Sn$ forming wire is manufactured by assembling an Nb rod into a CuSn alloy tube and executing the stretching process. The single-core $Nb_3Sn$ forming wire is again assembled into the CuSn tube having 19 holes and the stretching process is executed, thereby manufacturing the multi-core $Nb_3Sn$ forming wire and using it for the superconductive filaments 14. The superconductive filaments 14 made of the multi-core $Nb_3Sn$ forming wire are again assembled into the diamagnetic material 10 made of a CuSn tube in which holes have been formed in an outer layer portion and a center portion, thereby completing an $Nb_3Sn$ billet.

The paramagnetic material 7 made of the Ta tube for an intermediate layer is assembled into a hole of a center portion of the completed billet and, further, the diamagnetic material 2 made of the Cu rod for an innermost layer is assembled. After that, the wire rod is formed into a clad shape by the stretching process. Further, the wire-drawing process is executed until the rod diameter reaches 1.0 mm while performing intermediate annealing. In this manner, the low-magnetic superconductive wire rod made of the $Nb_3Sn$ composite wire is manufactured. The dimensions and thicknesses of the CuSn tube, Cu rod, Ta tube, and the like in this instance are determined in such a manner that the magnetic susceptibility of the material which is used is preliminarily measured in the same conditions as those of the environment where the antenna coil is used and at such a mixture ratio that the magnetism approaches zero as close as possible is obtained. The obtained wire rod is thermally processed in Ar at 650 °C for 200 hours, thereby forming the $Nb_3Sn$ composite wire.

Subsequently, the magnetic susceptibility of the manufactured $Nb_3Sn$ composite wire is measured. Thus, it is equal to $-6.0 \times 10^{-8}$ as a volume magnetic susceptibility.

It has been found that the small volume magnetic susceptibility which is almost equal to that obtained according to the mixture ratio is obtained.

Subsequently, the manufactured Nb$_3$Sn composite wire is wound into a solenoid coil shape around the bobbin made of the low-magnetic material such as quartz glass and, thereafter, a thermal process is executed, thereby forming the Nb$_3$Sn composite wire. After that, the Q value is measured. Thus, the Q value is equal to 3000, and it has been found that such a value is larger than that of the Comparison.

By using the superconductive wire whose magnetic susceptibility has been reduced as mentioned above, the antenna coil wire which satisfies both of the large Q value and the low magnetism can be formed.

Effects similar to those mentioned above are obtained even by the following methods.

Although the materials which can be combined are similar to those in the embodiment 1, since the Nb$_3$Sn forming and thermal processes are executed, it is desirable to use a material whose melting point is equal to 700 °C or more.

The wire rod cross-sectional structure is not limited to that mentioned above but an arbitrary structure can be used, and a similar effect is obtained so long as the mixture ratio of Ta and Cu in the center portion is maintained in a manner similar to that in the embodiment 1.

As a stretching process, a similar effect is also obtained even by using any one of the drawing bench process, extruding process, another stretching process, isostatic pressing process, rolling process, and the like.

Although the final processing diameter has been set to 1.0 mm in this instance, it can arbitrarily be determined according to the specifications such as inductance and dimensions of the antenna coil. It is desirable to set the final processing diameter to a value within the range from 0.1 to 3.0 mm from the viewpoint of the actual operation.

Although the volume magnetic susceptibility is equal to -6.0 x 10$^{-8}$ according to the present manufacturing of the wire rod, if a deviation occurs in the mixture ratio due to an influence upon stretching, the low magnetism can also be realized by forming a predetermined film to the outermost layer and finely adjusting it.

Although the wire rod has been formed into the circular shape, a similar effect is obtained even if it has the flat-type shape, hexagonal shape, or rectangular shape.

Although the diameter of the superconductive filament has been set to 5 μm in the present example, it has been found that the smaller the diameter is, the larger is the Q value.

Although the number of superconductive filaments has been set to 200, a similar effect is obtained by using an arbitrary number of superconductive filaments so long as the number of necessary Ics or more can be assured. In order to adjust the magnetism of the superconductive filaments, it is desirable to use superconductive filaments of a number which is almost equal to the number of necessary Ics.

[Embodiment 4]

In order to obtain a larger Q value in the wire rod of the structure in the embodiment 3, it is desirable to further reduce the resistance of the whole wire rod. For this purpose, such a technique that the superconductive filaments are exposed to the outermost periphery of the wire rod has been examined.

Fig. 8 shows the cross-sectional structure of an Nb$_3$Sn exposed composite circular wire rod which is used as a low-magnetic superconductive wire rod 12 manufactured in this example. After the low-magnetic superconductive wire rod was formed by the method mentioned in the embodiment 3, a part of the diamagnetic material 10 made of the CuSn alloy in the outermost periphery is etched, thereby exposing a part of the superconductive filaments 14. According to the wire rod for the antenna coil, since the superconductive filaments 14 are exposed, the resistance can be further extremely reduced, and the Q value is remarkably improved. In the case of this structure, although one surface in the laminate structure or the like faces the magnetic field, a number of superconductive filaments exist, so that the larger Q value is obtained.

In this example, the step of exposing the Nb$_3$Sn layer is important. In the case of the etching of the Cu or CuSn alloy, it is generally desirable to use a nitric acid as an etchant. However, it is necessary to preliminarily adjust the solution so that a predetermined amount of CuSn can be dissolved. Although a solution such as a fused metal or the like other than the nitric acid can be used, since it is important that the Nb$_3$Sn layer is directly exposed, such a process that CuSn remains in the outer peripheral portion is undesirable.

[Embodiment 5]

Although the effects have been proved by Nb$_3$Sn in the embodiments 3 and 4, a similar effect is obtained even if the superconductive filaments are replaced by NbTi or another superconductive substance.

Fig. 9 shows an example of a low-magnetic superconductive wire rod 13 using NbTi. In this embodiment, the center portion is formed by the diamagnetic material 2 made of the Cu rod, its outer periphery is formed by the paramagnetic material 7 made of the Ta tube, and its outside is formed by the diamagnetic material 2 made of the Cu tube. The superconductive filaments 14 exist in a part of the outermost layer, and a part of the filaments are exposed.

As another example other than the combination of those materials, various paramagnetic materials and various diamagnetic materials can be combined so as to obtain the low magnetic susceptibility and a similar effect is obtained. It is important to select the material of the superconductive filaments according to the use environment of the antenna coil. In a magnetic field of 10 T or less, it is effective to use NbTi having excellent flexibility. In an atmosphere of a temperature of 20 K or higher, it is effective to use $MgB_2$ or an oxide system. In a high magnetic field of 20 T or more, it is effective to use $Nb_3Al$.

[Embodiment 6]

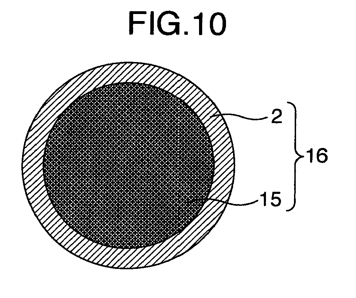

Fig. 10 shows a result of measurement of a low-magnetic wire rod 16 manufactured by the PIT (Powder In Tube) method. The PIT method is a method of forming a wire rod by filling powder in a tube. In the present example, there is used a method whereby Cu powder and A1 powder are mixed at such a ratio that the low magnetism can be obtained, thereby forming low-magnetic modified powder 15, and the diamagnetic material 2 made of the Cu tube is filled with the low-magnetic modified powder 15. After that, the stretching process is executed, and the magnetic susceptibility and the Q value are measured. Thus, it has been found that an effect similar to that in the case of the embodiment 1 is obtained.

Although the antenna coil which is used for the NMR probe has been described above, the invention can also be applied and developed to analyzing apparatus using a high uniform magnetic field in a manner similar to that in the NMR.

It should further be understood by those skilled in the art that although the foregoing description has been made on embodiments of the invention, the invention is not limited thereto, and various changes and modifications may be made without departing from the spirit of the invention and the scope of the appended claims.

**Claims**

1. Antenna coil for an NMR probe, wherein the coil is made of a wire rod (1; 4; 5; 6; 8; 9; 11; 12; 13; 16) obtained by combining and integrating two or more kinds of materials (2, 3; 10, 7) having different magnetisms, the magnetisms of the materials assembled by combining the two or more kinds of materials having the different magnetisms are set off, and the coil is formed in a solenoid shape.

2. Antenna coil for an NMR probe according to claim 1, wherein the wire rod (1; 4; 5; 6; 8; 9; 11; 12; 13; 16) has a circular, rectangular, flat-type or polygonal cross-sectional shape.

3. Antenna coil for an NMR probe according to claim 1 or 2, wherein superconductive filaments (14) are provided in the outer peripheral portion of the wire rod (11; 12; 13) and preferably in the outermost layer (2; 10) thereof.

4. Antenna coil for an NMR probe according to claim 3, wherein the superconductive material of the superconductive filaments (14) is selected from Nb system superconductors such as NbTi, NbZr, $Nb_3Sn$ and $Nb_3Al$, $MgB_2$ and oxide system superconductors such as Bi system oxide superconductors.

5. Antenna coil for an NMR probe according to claim 3 or 4, wherein a part of the superconductive filaments (14) are exposed.

6. Antenna coil for an NMR probe according to any of claims 1 to 5, wherein the coil is placed or adapted to be placed in an atmosphere of a temperature of 10 K or less.

7. Antenna coil for an NMR probe according to any of claims 1 to 6, further comprising a winding bobbin made of a low-magnetic material.

8. Antenna coil for an NMR probe according to any of claims 1 to 7, made of a wire rod (1; 4; 5; 6; 8; 9; 11; 12; 13; 16) obtained by combining a paramagnetic material (3; 7) and a diamagnetic material (2; 10), wherein the paramagnetic material is at least one material selected from Al, Pt, Cr, Ta, W, K, Ca, Sc, Ti, V, Mn, Rb, Sr, Y, Zr, Nb, Mo, Tc, Ru, Rh, Pd, and their alloys, and the diamagnetic material is at least one material selected from Au, Ag, Cu, and their alloys, preferably CuNi or CuSn.

9. Anntenna coil for an NMR probe according to any of claims 1 to 8, made of a wire rod (1; 4; 5; 6; 8; 9; 11; 12; 13; 16) wherein a film having a magnetism which sets off the magnetic susceptibility is formed on the outermost periphery thereof.

10. Low-magnetic wire rod (1; 4; 5; 6; 8; 9; 11; 12; 13; 16) for an antenna coil for an NMR probe, obtained by combining and integrating two or more kinds of materials (2, 3; 10, 7) having different magnetisms, and the magnetisms of the materials assembled by combining the two or more kinds of materials having the different magnetisms are set off.

11. Wire rod (1; 4; 5; 6; 8; 9; 11; 12; 13; 16) according to claim 10, having a circular, rectangular, flat-type or polygonal cross-sectional shape.

12. Wire rod (11; 12; 13) according to claim 10 or 11, wherein superconductive filaments (14) are provided in the outer peripheral portion of the wire rod (11; 12; 13), and the wire rod is superconductive.

13. Wire rod (11; 12; 13) according to claim 12, wherein the superconductive filaments (14) are provided in the outermost layer (2; 10) thereof.

14. Wire rod (11; 12; 13) according to claim 12 or 13, wherein the superconductive material of the superconductive filaments (14) is selected from Nb system superconductors such as NbTi, NbZr, $Nb_3Sn$ and $Nb_3Al$, $MgB_2$ and oxide system superconductors such as Bi system oxide superconductors.

15. Wire rod according to any of claims 12 to 14, wherein a part of the superconductive filaments (14) are exposed.

16. Wire rod according to any of claims 10 to 15, wherein the two or more kinds of materials having the different magnetisms are materials obtained by combining a paramagnetic material (3; 7) and a diamagnetic material (2; 10), wherein the paramagnetic material is at least one material selected from Al, Pt, Cr, Ta, W, K, Ca, Sc, Ti, V, Mn, Rb, Sr, Y, Zr, Nb, Mo, Tc, Ru, Rh, Pd, and their alloys, and the diamagnetic material is at least one material selected from Au, Ag, Cu, and their alloys, preferably CuNi or CuSn.

17. Wire rod (11; 12; 13) according to any of claims 12 to 16, wherein a film having a magnetism which sets off the magnetic susceptibility is formed on the outermost periphery thereof.

18. NMR system for detecting NMR signals using an NMR probe comprising an antenna coil, wherein the anntenna coil is a coil according to any of claims 1 to 9.

19. NMR system according to claim 18, wherein the antenna coil is placed or adapted to be placed in an atmosphere whose temperature has been reduced to 10 K or less.

20. NMR system according to claim 18 or 19, comprising a cooling system for cooling the probe or the antenna coil at a temperature of 10°K or less.

# FIG.1

# FIG.2

# FIG.3

## FIG.4

## FIG.5

## FIG.6

## FIG.7

## FIG.8

## FIG.9

FIG.10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003011268 A